# DEMANDE DE BREVET EUROPEEN

(11) **EP 2 117 042 A1**
(43) Date de publication de la demande: **11.11.2009**
(21) Numéro de dépôt: 09159385.5
(22) Date de dépôt: 05.05.2009
(51) Int. Cl.: H01L 21/768

(54) **Procede de realisation de cavites d'air dans des microstructures, notamment du type structures d'interconnexions a cavites d'air pour circuit integre**

(30) Priorité: 06.05.2008 FR 0852998
(71) Demandeur: COMMISSARIAT A L'ENERGIE ATOMIQUE, 75015 Paris (FR)
(72) Inventeur: ZENASNI, Aziz, 38610, GIERES (FR)
(74) Mandataire: Ilgart, Jean-Christophe

(57) **Abrégé**

L'invention se rapporte à un procédé pour réaliser au moins une cavité d'air dans une microstructure, qui comprend :
1) la fourniture d'une microstructure comprenant au moins une cavité remplie d'un matériau sacrificiel qui se décompose à partir d'une température θ₁, cette cavité étant délimitée sur au moins une partie de sa surface par une membrane non poreuse, constituée d'un matériau formant une matrice et d'un agent porogène qui se décompose à une température θ₂ < θ₁ d'au moins 20°C et qui est dispersé dans cette matrice ;
2) le traitement de la microstructure à une température ≥ à θ₂ mais < à θ₁ pour décomposer sélectivement l'agent porogène ; puis
3) le traitement de la microstructure à une température ≥ à θ₁ pour décomposer le matériau sacrificiel.

Applications : fabrication de structures d'interconnexions à cavités d'air pour circuit intégré et de toute autre microstructure dans les industries microélectronique et microtechnologique.

## Description

### DOMAINE TECHNIQUE

La présente invention se rapporte à un procédé permettant de réaliser des cavités d'air dans des microstructures.

Dans ce qui précède et ce qui suit, on utilise l'expression « *cavité d'air* » comme équivalent français de l'expression anglaise « *air gap* », laquelle est utilisée dans la littérature anglo-saxonne pour désigner une cavité qui peut être remplie d'air, d'un gaz autre que l'air et, en particulier, d'un gaz neutre tel que l'argon, ou bien encore de vide.

La présente invention est notamment susceptible d'être utilisée dans la fabrication de structures d'interconnexions à cavités d'air pour circuit intégré.

Toutefois, elle peut également être utile pour réaliser d'autres types de microstructures à cavités d'air comme, par exemple, des microsystèmes électromécaniques (ou MEMS) à cavités résonantes du type BAW (pour « *Bulk Acoustic Wave* »), ou encore des microbatteries.

### ÉTAT DE LA TECHNIQUE ANTÉRIEURE

L'un des schémas d'intégration utilisés à ce jour pour la réalisation de structures d'interconnexions à cavités d'air pour circuit intégré prévoit d'insérer les lignes métalliques d'un même niveau dans une couche d'un matériau sacrificiel qui consiste en un polymère décomposable à la chaleur, à recouvrir le tout d'une membrane diélectrique, puis à effectuer un recuit thermique, éventuellement assisté par UV, de manière à décomposer le matériau sacrificiel et à l'extraire de la structure par volatilisation au travers de la membrane diélectrique.

Ce schéma implique que la membrane diélectrique ait une porosité suffisante pour laisser passer le matériau sacrificiel une fois celui-ci décomposé.

Aussi a-t-il été proposé, pour réaliser cette membrane, de déposer un film hybride comprenant, d'une part, un matériau diélectrique formant une matrice et, d'autre part, un agent porogène dispersé dans cette matrice, et de profiter du recuit thermique destiné à extraire le matériau sacrificiel sous-jacent pour décomposer l'agent porogène et transformer ainsi le film hybride en un film diélectrique poreux. Des films diélectriques poreux obtenus de la sorte sont, par exemple, les films en BD2x décrits par Bailly et al. (Plasma Etch and Strip in Microelectronics, 1er séminaire international, 10-11 septembre 2007, Louvain, Belgique), qui sont des films de type SiCOH à 25% de porosité.

Or, l'expérience montre que, dans ce cas, on obtient à l'issue du recuit thermique des cavités qui renferment des résidus de matériau sacrificiel (signant une décomposition et une extraction incomplètes de ce matériau) et qui, du fait qu'elles ne sont que partiellement remplies d'air, ne peuvent conférer à la structure des performances électriques satisfaisantes.

Par ailleurs, ce schéma ne peut s'appliquer que si la création des cavités d'air est effectuée niveau par niveau, c'est-à-dire que les cavités d'un niveau d'interconnexions sont créées avant que ne soient réalisées les lignes métalliques du niveau d'interconnexions suivant.

Or, ceci génère un certain nombre de contraintes.

En particulier, comme la création de cavités d'air dans un niveau d'interconnexions a pour effet de diminuer la résistance mécanique de la structure, les opérations mécaniques nécessaires à l'intégration des niveaux d'interconnexions suivants comme, par exemple, les opérations de polissage mécano-chimiques sont effectuées alors que la structure est mécaniquement fragilisée, et ce d'autant plus que des cavités d'air sont crées sur plusieurs niveaux d'interconnexions, ce qui peut conduire à un effondrement ou à un écrasement de la structure et donc à sa destruction.

De plus, lors des opérations de gravure et de métallisation nécessaires à la réalisation des vias, c'est-à-dire des ponts métalliques qui assurent la connexion entre les lignes métalliques de deux niveaux d'interconnexions attenants, un désalignement des vias
- qui est un phénomène qui se produit assez couramment lors de la fabrication de structures d'interconnexions
- peut avoir pour conséquences que la gravure débouche sur une cavité d'air sous-jacente et que la métallisation s'accompagne ensuite d'un dépôt de métal dans cette cavité avec à la clé, l'obtention d'une structure défaillante et aux mauvaises performances électriques.

### EXPOSÉ DE L'INVENTION

L'invention vise justement à fournir un procédé qui permet de réaliser une ou plusieurs cavités d'air dans une microstructure par extraction au travers d'une membrane poreuse d'un matériau sacrificiel qui se décompose à la chaleur, et qui résout tous ces problèmes puisqu'il conduit à l'obtention de cavités d'air exemptes de résidus de matériau sacrificiel et, dans le cas où des cavités d'air doivent être réalisées dans plusieurs niveaux d'une même microstructure, de ne créer ces cavités qu'une fois l'intégration du dernier de ces niveaux réalisée.

Ce procédé comprend successivement :
1) la fourniture d'une microstructure comprenant au moins une cavité remplie d'un matériau sacrificiel qui se décompose à partir d'une température θ₁, cette cavité étant délimitée sur au moins une partie de sa surface par une membrane non poreuse, constituée d'un matériau formant une matrice et d'un agent porogène qui se décompose à une température θ₂ inférieure à θ₁ d'au moins 20°C et qui est dispersé dans cette matrice ;
2) le traitement thermique (ou recuit) de la microstructure à une température au moins égale à θ₂ mais inférieure à θ₁ pour décomposer sélectivement l'agent porogène et rendre ainsi la membrane poreuse ; et
3) le traitement thermique de la microstructure à une température au moins égale à θ₁ pour décomposer le matériau sacrificiel et obtenir son extraction de la cavité au travers de la membrane rendue poreuse à l'étape 2), moyennant quoi on obtient une cavité d'air à la place de la cavité remplie de matériau sacrificiel.

Ainsi, selon l'invention, c'est en décomposant dans un premier temps l'agent porogène présent dans la membrane non poreuse, puis secondairement le matériau sacrificiel sous-jacent - ce qui revient à créer la porosité de la membrane avant que ne commence la décomposition du matériau sacrificiel - que l'on obtient des cavités d'air exemptes de résidu de ce matériau.

Le matériau formant la matrice de la membrane non poreuse peut être tout matériau, de préférence à base de silice, connu pour, d'une part, être stable à des températures élevées telles que celles qui sont classiquement utilisées dans les procédés de fabrication propres à l'industrie microélectronique, d'autre part, être apte à être déposé en couches minces et, dans le cas où la microstructure est une structure d'interconnexions pour circuit intégré, présenter en outre une constante diélectrique faible.

Ainsi, il peut notamment s'agir d'un polymère ayant des motifs siliciés de la famille des silsesquioxanes comme un méthylsilsesquioxane, un hydrosilsesquioxane ou un mélange de ceux-ci, auquel cas la membrane non poreuse est avantageusement formée par enduction centrifuge ou « *spin coating* » en anglais, à partir d'une solution comprenant ce polymère et l'agent porogène dans un solvant organique du type acétone, cyclohexanone, tétrahydrofuranne, méthyléthylcétone, isopropanol, lactate d'éthyle ou éther monométhylique du propylène glycol.

En variante, il peut également s'agir d'un matériau silicié non polymérique tels que SiO₂, SiOₓC_{y}H_{z} ou SiOₓF_{y}, auquel cas la membrane non poreuse est avantageusement formée par dépôt chimique en phase vapeur, encore connu sous le sigle CVD pour « ***C**hemical **V**apor **D**eposition* », ou par dépôt chimique en phase vapeur assisté par plasma, encore connu sous le sigle PECVD pour « ***P**lasma **E**nhanced **C**hemical **V**apor **D**eposition* ».

L'agent porogène dispersé dans cette matrice peut, lui, être tout matériau qui est susceptible de perdre son intégrité structurelle sous l'effet de la chaleur et qui est apte à être déposé, conjointement avec le matériau destiné à former la matrice, par une technique de dépôt en couches minces et, en particulier, par enduction centrifuge, CVD ou PECVD, de sorte à être présent dans cette matrice, à l'issue du dépôt, sous une forme dispersée, avantageusement sous la forme de nanoparticules.

Ainsi, il peut notamment s'agir d'un polymère résultant de la polymérisation d'un ou plusieurs monomères à une ou plusieurs insaturations éthyléniques choisis parmi :
- les monomères éthyléniques comportant un ou plusieurs groupes -CO₂H et leurs esters, ainsi que les monomères éthyléniques comportant un ou plusieurs groupes CN, tels que :
   - les (méth)acryliques, éventuellement substitués, comme l'acide acrylique, l'acide méthacrylique ou l'acide crotonique ;
   - les (méth)acrylates d'alkyles et d'alkylènes comme les (méth)acrylates de méthyle, d'éthyle, de propyle, de butyle, d'octyle, de 2-éthylhexyle, de cyclohexyle ou de 2-hexène, et leurs dérivés obtenus par substitution desdits alkyles et alkylènes comme les (méth)acrylates de méthoxyéthyle, d'éthoxyéthyle, d'éthoxypropyle, d'hexafluoroisopropyle, de 2-hydroxyéthyle, de 2- ou 3-hydroxypropyle, de 2,3-dihydroxypropyle, de polyéthoxyéthyle ou de polyéthoxy-propyle ;
   - les (méth)acrylates d'aryles tels que les (méth)acrylates de phényle ou de benzyle, et leurs dérivés obtenus par substitution desdits aryles ;
   - les (méth)acrylates et di(méth)-acrylates de poly(éthylène glycol) ou de poly(propylène glycol) ;
   - les (méth)acrylamides et leurs dérivés N-substitués comme le N-méthylacrylamide, le N,N-diméthylacrylamide, le N,N-diméthylméthacrylamide, l'acide 2-acrylamido-2-méthyl-1-propanesulfonique, le N-[3-(diméthylamino)propyl]acrylamide ou le 2-(N,N-diéthyl-amino)éthylméthacrylamide ;
   - les acides dicarboxyliques insaturés comme l'acide maléique, l'acide fumarique ou l'acide itaconique, et leurs esters comme le maléate de diméthyle, le fumarate de diméthyle ou le fumarate de diéthyle ;
   - les monomères nitrilés comme l'acrylonitrile ;
- les monomères éthyléniques comportant un groupe hétérocyclique tels qu'un cycle pyridine (par exemple, la 2-vinylpyridine, la 4-vinylpyridine, la 2-méthyl-5-vinylpyridine, la 4-méthyl-5-vinylpyridine ou la N-méthyl-4-vinylpyridine), un cycle pipéridine (par exemple, la N-méthyl-4-vinylpipéridine), un cycle imidazole (par exemple, le 2-méthyl-1-vinylimidazole), un cycle pyrrolidone (par exemple, la N-vinyl-pyrrolidone) ou encore un cycle pyrroledione (par exemple, le maléimide) ;
- les monomères éthyléniques comportant un groupe aromatique exclusivement hydrocarboné tels que le styrène ou l'α-méthylstyrène ;
- les monomères éthyléniques comportant un groupe -O-CO-R avec R représentant un groupe alkyle (par exemple, l'acétate de vinyle ou le propionate de vinyle), ou un groupe aryle (par exemple, le benzoate de vinyle) ;
- les monomères éthyléniques comportant un groupe -OR, connus sous la terminologie de vinyléthers, avec R représentant un groupe alkyle (par exemple, le méthylvinyléther), ledit groupe pouvant comporter un ou plusieurs atomes d'oxygène (par exemple, l'éthoxyéthylvinyléther) ou un ou plusieurs groupes amino (par exemple, le diméthylaminoéthylvinyléther) ;
- les monomères éthyléniques exclusivement hydrocarbonés comme le 1- ou 2-hexène, le norbornène, l'acénaphtylène ou les terpènes tel que l'α-terpinène ; et
- les monomères éthyléniques comprenant un groupe -C(O)R avec R représentant un groupe alkyle (par exemple, la vinylméthylcétone.

Comme précédemment mentionné, l'agent porogène peut être un copolymère résultant de la polymérisation de plusieurs monomères éthyléniques différents, éventuellement en présence d'agents de réticulation tels que le divinylbenzène ou le bis-maléimide. Ainsi, il peut notamment être un polymère réticulé styrène/divinylbenzène, éventuellement avec maléimide ou bis-maléimide.

D'autres types d'agent porogène peuvent encore être utilisés comme, par exemple, un polyamide, un éther de polyarylène, un chlorure de polyvinyle ou un composite acrylate/méthacrylate multifonctionnel dit "*B-staged*".

Quant au matériau sacrificiel, il peut être choisi parmi les matériaux qui viennent d'être mentionnés pour l'agent porogène, ou bien parmi les matériaux carbonés à structure amorphe CₓH_{y} qui se décomposent à des températures inférieures à 500°C. De tels matériaux peuvent notamment être obtenus par PECVD à partir de précurseurs exclusivement hydrocarbonés du type méthane, propane, butane, acétylène et analogues, en mélange avec un ou plusieurs gaz neutres tels que l'argon ou l'azote.

Conformément à l'invention, il est possible d'utiliser, comme agent porogène et comme matériau sacrificiel, des matériaux différents dont les températures de décomposition présentent au moins 20°C d'écart, la température de décomposition de l'agent porogène devant être la plus basse des deux.

Toutefois, on préfère pour des considérations pratiques utiliser le même matériau et jouer sur sa température de dépôt sachant que, plus un matériau de type sacrificiel est déposé à une température élevée, plus il convient de lui appliquer une température élevée pour le décomposer et, donc, l'extraire d'une matrice ou d'une cavité dans laquelle il se trouve.

Ainsi, par exemple, un recuit thermique de 275°C permet de décomposer du poly(α-terpinène) ayant été déposé par PECVD à une température de 200°C, alors qu'il ne permet pas de décomposer ce matériau lorsqu'il a été déposé à 250°C par la même technique. De manière similaire, un recuit thermique de 350°C permet de décomposer du poly(α-terpinène) ayant été déposé par PECVD à une température de 275°C, alors qu'il ne permet pas de décomposer ce matériau lorsqu'il a été déposé à 300°C par la même technique.

Ceci peut être mis à profit pour, par exemple, fournir à l'étape 1) une microstructure dans laquelle :
- la membrane non poreuse comprend du poly(α-terpinène) comme agent porogène, par exemple dans une matrice siliciée non polymérique de type SiOₓC_{y}H_{z}, et a été formée par PECVD à une température de l'ordre de 275°C, tandis que
- le matériau sacrificiel est du poly(α-terpinène) ayant été déposé par PECVD à une température de l'ordre de 300°C,
moyennant quoi l'étape 2) de décomposition sélective de l'agent porogène peut ensuite être conduite à 350°C, tandis que l'étape 3) de décomposition du matériau sacrificiel peut, elle, être conduite à une température de 400°C.

Dans tous les cas, les traitements thermiques des étapes 2) et 3) sont avantageusement effectués sous rayonnement ultraviolet, l'expérience ayant, en effet, montré qu'une irradiation par des ultraviolets facilite la décomposition thermique et, partant, l'extraction de l'agent porogène et du matériau sacrificiel.

Selon une disposition particulièrement préférée de l'invention, la microstructure est une structure d'interconnexions pour circuit intégré, qui comprend au moins un niveau d'interconnexions formé d'une pluralité de lignes métalliques séparées les unes des autres par des cavités d'air, auquel cas le procédé comprend dans l'ordre qui suit :
a) le dépôt, sur un substrat, du matériau sacrificiel sous la forme d'une couche ;
b) la gravure de cette couche selon un motif correspondant à la disposition devant être présentée par les lignes métalliques dans le niveau d'interconnexions ;
c) la formation de lignes métalliques dans les zones gravées de matériau sacrificiel ;
d) le dépôt, sur les lignes métalliques ainsi formées et sur les parties non gravées de la couche de matériau sacrificiel, de la membrane non poreuse ;
e) le traitement thermique de la microstructure à une température au moins égale à θ₂ mais inférieure à θ₁ ; et
f) le traitement thermique de la microstructure à une température au moins égale à θ₁.

Dans le cas où cette structure d'interconnexions est prévue pour comprendre deux, trois, quatre, ..., niveaux d'interconnexions adjacents les uns aux autres, formé chacun d'une pluralité de lignes métalliques séparées par des cavités d'air, alors :
- on réalise l'intégration de chaque niveau d'interconnexions en utilisant un couple matériau sacrificiel/agent porogène dont l'agent porogène est capable de se décomposer à partir d'une température inférieure d'au moins 20°C à la température minimale de décomposition du matériau sacrificiel, et dont le matériau sacrificiel est capable de se décomposer à partir d'une température inférieure d'au moins 20°C de la température minimale de décomposition de l'agent porogène utilisé pour réaliser l'intégration du niveau d'interconnexions sous-jacent ; moyennant quoi
- on crée les cavités d'air, une fois le dernier niveau d'interconnexions intégré, en traitant la structure par des températures de plus en plus élevées, éventuellement sous irradiation UV, de manière à décomposer sélectivement l'agent porogène, puis le matériau sacrificiel présents dans chaque niveau d'interconnexions, en allant du niveau d'interconnexions intégré en dernier jusqu'au niveau d'interconnexions intégré en premier.

Ainsi, par exemple, pour une structure d'interconnexions à deux niveaux d'interconnexions adjacents, on effectue dans l'ordre qui suit :
a) le dépôt, sur un substrat, d'une couche du matériau sacrificiel se décomposant à partir de la température θ₁ dénommé ci-après « *premier matériau sacrificiel* » ;
b) la gravure de cette couche selon un motif correspondant à la disposition devant être présentée par les lignes métalliques dans le premier niveau d'interconnexions ;
c) la formation de lignes métalliques dans les zones gravées de la couche du premier matériau sacrificiel ;
d) le dépôt, sur les lignes métalliques ainsi formées et sur les parties non gravées de la couche du premier matériau sacrificiel, de la membrane non poreuse renfermant l'agent porogène se décomposant à la température θ₂, dénommée ci-après « *première membrane non poreuse* » ;
e) le dépôt, sur la première membrane non poreuse, d'une couche d'un deuxième matériau sacrificiel qui se décompose à partir d'une température θ₃ inférieure à θ₂ d'au moins 20°C ;
f) la gravure de la couche du deuxième matériau sacrificiel selon un motif correspondant à la disposition devant être présentée par les lignes métalliques dans le deuxième niveau d'interconnexions ;
g) la formation de lignes métalliques dans les zones gravées du deuxième matériau sacrificiel ;
h) le dépôt, sur les lignes métalliques formées à l'étape g) et sur les parties non gravées de la couche du deuxième matériau sacrificiel, d'une deuxième membrane non poreuse constituée d'un matériau formant une matrice et d'un agent porogène qui se décompose à partir d'une température θ₄ inférieure à θ₃ d'au moins 20°C et qui est dispersé dans cette matrice ;
i) le traitement thermique de la microstructure à une température au moins égale à θ₄ mais inférieure à θ₃ pour décomposer sélectivement l'agent porogène présent dans la deuxième membrane non poreuse ;
j) le traitement thermique de la microstructure à une température au moins égale à θ₃ mais inférieure à θ₂ pour décomposer sélectivement le deuxième matériau sacrificiel ;
k) le traitement thermique de la microstructure à une température au moins égale à θ₂ mais inférieure à θ₁ pour décomposer sélectivement l'agent porogène présent dans la première membrane non poreuse ; et
l) le traitement thermique de la microstructure à une température au moins égale à θ₁ pour décomposer le premier matériau sacrificiel.

Dans tous les cas, la ou les couches de matériau sacrificiel présentent typiquement une épaisseur de 150 à 250 nm et, idéalement, de l'ordre de 200 nm, tandis que la ou les membranes non poreuses présentent typiquement une épaisseur de 50 à 100 nm et, idéalement, de l'ordre de 100 nm.

Le procédé qui vient d'être décrit présente de nombreux avantages. En effet, non seulement il permet d'obtenir des cavités d'air sans résidu de matériau sacrificiel et, dans le cas où des cavités d'air doivent être réalisées dans plusieurs niveaux d'une même microstructure, de ne créer ces cavités qu'une fois l'intégration du dernier de ces niveaux réalisée, mais il présente également l'avantage :
- d'être simple à mettre en oeuvre ;
- de pouvoir être entièrement mis en oeuvre à des températures inférieures à 450°C, ce qui est très appréciable pour des applications qui ne tolèrent pas l'utilisation de températures très élevées ;
- de ne pas utiliser d'agents d'attaque chimique comme l'acide fluorhydrique qui, dans certaines configurations, peuvent détériorer les couches adjacentes à celles du matériau sacrificiel ; et
- d'utiliser des matériaux peu stressés, ce qui permet de s'affranchir des contraintes de stress observés lors d'intégrations nécessitant un empilement de couches.

D'autres caractéristiques et avantages du procédé selon l'invention apparaîtront mieux à la lecture du complément de description qui suit et qui se rapporte à un exemple de mise en oeuvre de ce procédé.

Bien entendu, cet exemple n'est donné qu'à titre d'illustration de l'objet de l'invention et ne constitue en aucun cas une limitation de cet objet.

### BRÈVE DESCRIPTION DES FIGURES

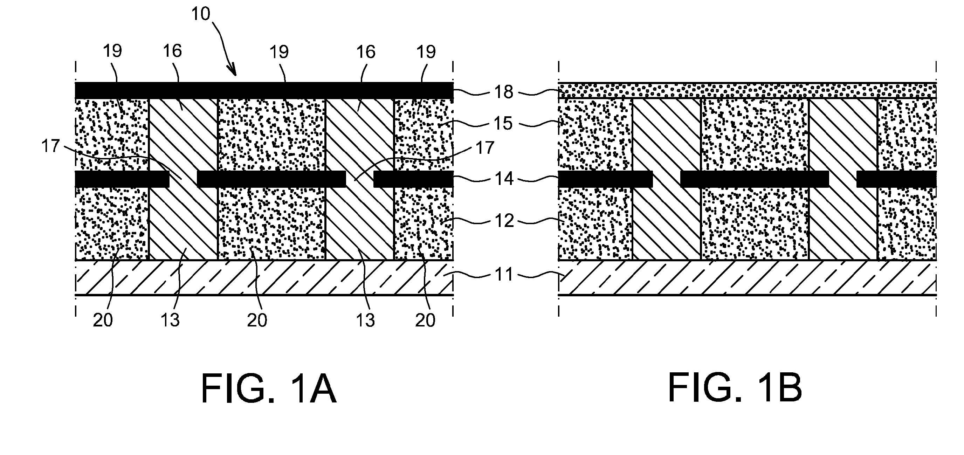

Les figures 1A à 1E illustrent de façon schématique un premier exemple de mise en oeuvre du procédé de réalisation de cavités d'air selon l'invention, dans le cas d'une structure d'interconnexions pour circuit intégré.

Pour des raisons de clarté, les dimensions des différents constituants de la structure représentée sur ces figures ne sont pas en proportion avec leurs dimensions réelles.

### EXPOSÉ DÉTAILLÉ D'UN MODE DE MISE EN OEUVRE PARTICULIER

On se réfère aux figures 1A à 1E qui illustrent sous une forme schématique un exemple de mise en oeuvre du procédé selon l'invention pour la réalisation de cavités d'air dans une structure d'interconnexions pour circuit intégré.

Par souci de simplification, cette structure ne comprend que deux niveaux d'interconnexions à cavités d'air mais il va de soi qu'elle pourrait présenter un nombre plus élevé de niveaux d'interconnexions à cavités d'air, par exemple 3, 4 ou 5 niveaux, sans que cela ne change ce mode de mise en oeuvre dans son principe.

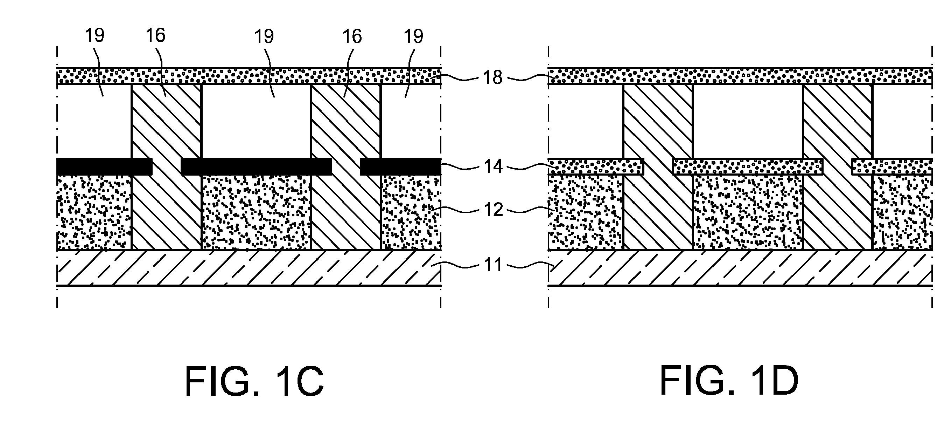

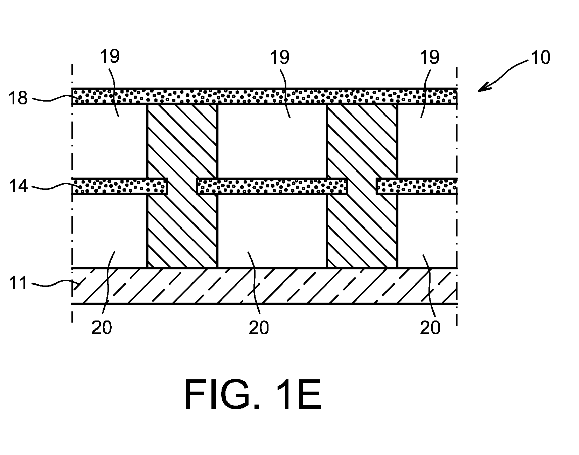

On réalise tout d'abord la structure 10 montrée sur la figure 1.

Pour ce faire, on dépose, sur un substrat semi-conducteur 11, typiquement en silicium, une première couche 12 de poly(α-terpinène) de 200 nm environ d'épaisseur. Ce dépôt est effectué par PECVD, à partir d'α-terpinène et d'un gaz porteur, en l'espèce de l'hélium, par exemple dans un réacteur à couplage capacitif du type Producer^{®} SE 300 mm de la société Applied Materials, et en utilisant les paramètres opératoires suivants :
Excitation radiofréquence : 13,56 MHz
Pression de travail : 5 torrs (6,6 x 10² Pa)
Puissance : 300 W
Température de dépôt : 300°C
Flux d'α-terpinène : 1000 cm³/min
Flux d'hélium (gaz porteur) : 500 cm³/min
Durée du dépôt : 1 minute
Espace inter-électrodes (« spacing ») : 0,88 cm (350 milli-pouces) .

On intègre dans la couche 12 ainsi obtenue des lignes métalliques 13, typiquement en cuivre, pour obtenir un premier niveau d'interconnexions. Cette intégration peut être réalisée selon une route classique, c'est-à-dire par exemple :
■ définition d'un motif d'interconnexions sur la couche 12 de poly(α-terpinène) par un procédé de lithographie utilisant un masque dur ;
■ gravure de la couche 12 de poly(α-terpinène) au travers du masque jusqu'à révéler le substrat 11 ;
■ métallisation dans le motif de gravure et polissage mécano-chimique.

On dépose ensuite, sur ce premier niveau d'interconnexions, une première membrane 14, de 100 nm environ d'épaisseur, qui est formée d'une matrice de type SiOₓC_{y}H_{z} et de poly(α-terpinène) dispersé dans cette matrice sous la forme de nano-particules. Ce dépôt est effectué par PECVD à partir de diéthoxyméthylsilane, d'α-terpinène et d'un gaz porteur, en l'espèce de l'hélium, par exemple dans un réacteur à couplage capacitif du type Producer^{®} SE 300 mm de la société Applied Materials, et en utilisant les paramètres opératoires suivants :
Excitation radiofréquence : 13,56 MHz
Pression de travail : 8 torrs (1,07 kPa)
Puissance : 600 W
Température de dépôt : 275°C
Flux de diéthoxyméthylsilane : 1200 cm³/min
Flux d'α-terpinène : 1350 cm³/min
Flux d'hélium : 500 cm³/min
Durée du dépôt : 1 minute
Espace inter-électrodes (« spacing ») : 0,88 cm (350 milli-pouces) .

Après quoi, on dépose, sur la membrane 14, une seconde couche 15 de poly(α-terpinène), de 200 nm environ d'épaisseur, en utilisant le même procédé et les mêmes paramètres opératoires que ceux utilisés pour le dépôt de la couche 12 à l'exception de la température de dépôt qui est de 250°C au lieu de 300°C et de la durée de dépôt qui est de 45 secondes environ.

On intègre dans la couche 15 ainsi obtenue, également selon une route classique, des lignes métalliques 16 qui sont connectées respectivement aux lignes métalliques 13 par l'intermédiaire de vias 17, pour obtenir un second niveau d'interconnexions.

On dépose alors, sur ce dernier, une seconde membrane 18, de même épaisseur que la membrane 14, qui est formée d'une matrice de type SiOₓC_{y}H_{z} et de poly(α-terpinène) dispersé dans cette matrice sous la forme de nanoparticules, et dont le dépôt est effectué en utilisant le même procédé et les mêmes paramètres opératoires que ceux utilisés pour le dépôt de la membrane 14 à l'exception de la température de dépôt qui est de 200°C au lieu de 275°C et de la durée de dépôt qui est de 40 secondes environ.

On obtient ainsi la structure montrée sur la figure 1A qui comprend :
- des cavités 19, remplies de poly(α-terpinène), qui sont délimitées par les lignes métalliques 16 et les membranes 14 et 18 ; et
- des cavités 20, également remplies de poly(α-terpinène), qui sont délimitées par les lignes électriques 13, le substrat 11 et la membrane 14.

Puis, comme illustré sur les figures 1B à 1E, on soumet la structure 10 ainsi obtenue à quatre recuits successifs, d'une durée de 30 minutes chacun, que l'on réalise sous irradiation UV.

Le premier recuit est réalisé à 275°C de manière à décomposer sélectivement le poly(α-terpinène) présent dans la membrane 18 et rendre ainsi cette membrane poreuse (figure 1B).

Le deuxième recuit est réalisé à 300°C pour décomposer sélectivement la couche 15 de poly(α-terpinène), ce qui permet de transformer les cavités 19 en cavités d'air (figure 1C).

Le troisième recuit est réalisé à 350°C pour décomposer sélectivement le poly(α-terpinène) présent dans la membrane 14 et rendre ainsi cette membrane poreuse (figure 1D), tandis que le quatrième recuit est réalisé à la température de 400°C pour décomposer la couche 12 de poly(α-terpinène), ce qui permet de transformer les cavités 20 en cavités d'air.

On obtient ainsi la structure 10 montrée sur la figure 1E.

## Revendications

1. Procédé de réalisation d'au moins une cavité d'air dans une microstructure, du type comprenant l'extraction d'un matériau sacrificiel au travers d'une membrane poreuse par décomposition de ce matériau à la chaleur, lequel procédé comprend dans l'ordre qui suit :
1) la fourniture d'une microstructure comprenant au moins une cavité remplie d'un matériau sacrificiel qui se décompose à partir d'une température θ₁, cette cavité étant délimitée sur au moins une partie de sa surface par une membrane non poreuse, constituée d'un matériau formant une matrice et d'un agent porogène qui se décompose à une température θ₂ inférieure à θ₁ d'au moins 20°C et qui est dispersé dans cette matrice ;
2) le traitement thermique de la microstructure à une température au moins égale à θ₂ mais inférieure à θ₁ pour décomposer sélectivement l'agent porogène et rendre ainsi la membrane poreuse ; et
3) le traitement thermique de la microstructure à une température au moins égale à θ₁ pour décomposer le matériau sacrificiel et obtenir son extraction de la cavité au travers de la membrane rendue poreuse à l'étape 2), moyennant quoi on obtient une cavité d'air à la place de la cavité remplie de matériau sacrificiel.

2. Procédé selon la revendication 1, dans lequel le matériau formant la matrice de la membrane non poreuse est un polymère silicié de la famille des silsesquioxanes.

3. Procédé selon la revendication 1, dans lequel le matériau formant la matrice de la membrane non poreuse est un matériau silicié non polymérique, en particulier SiO₂, SiOₓC_{y}H_{z} ou SiOₓF_{y.}

4. Procédé selon l'une quelconque des revendications précédentes, dans lequel l'agent porogène est un polymère résultant de la polymérisation d'un ou plusieurs monomères à une ou plusieurs insaturations éthyléniques.

5. Procédé selon l'une quelconque des revendications précédentes, dans lequel le matériau sacrificiel est polymère résultant de la polymérisation d'un ou plusieurs monomères à une ou plusieurs insaturations éthyléniques, ou un matériau carboné à structure amorphe CₓH_{y} se décomposant à une température inférieure à 500°C.

6. Procédé selon l'une quelconque des revendications précédentes, dans lequel l'agent porogène et le matériau sacrificiel sont le même matériau.

7. Procédé selon la revendication 6, dans lequel l'agent porogène et le matériau sacrificiel sont du poly(α-terpinène).

8. Procédé selon l'une quelconque des revendications précédentes, dans lequel les traitements thermiques de la microstructure sont effectués sous rayonnement ultraviolet.

9. Procédé selon l'une quelconque des revendications précédentes, dans lequel la microstructure est une structure d'interconnexions pour circuit intégré, comprenant au moins un niveau d'interconnexions formé d'une pluralité de lignes métalliques séparées les unes des autres par des cavités d'air, et le procédé comprend dans l'ordre qui suit :
a) le dépôt, sur un substrat, du matériau sacrificiel sous la forme d'une couche ;
b) la gravure de cette couche selon un motif correspondant à la disposition devant être présentée par les lignes métalliques dans le niveau d'interconnexions ;
c) la formation de lignes métalliques dans les zones gravées de matériau sacrificiel ;
d) le dépôt, sur les lignes métalliques ainsi formées et sur les parties non gravées de la couche de matériau sacrificiel, de la membrane non poreuse ;
e) le traitement thermique de la microstructure à une température au moins égale à θ₂ mais inférieure à θ₁ ; et
f) le traitement thermique de la microstructure à une température au moins égale à θ₁.
